# EUROPEAN PATENT APPLICATION

(11) **EP 2 797 016 A2**
(43) Date of publication of application: **29.10.2014**
(21) Application number: 14164111.8
(22) Date of filing: 09.04.2014
(51) Int. Cl.: G06F 17/50

(54) **Radio frequency device placement tool**

(30) Priority: 24.04.2013 US 201313869789
(71) Applicant: Honeywell International Inc., Morristown, NJ 07962-2245 (US)
(72) Inventor: Kamalakannan, Arunkumar, Morristown, NJ 07962-2245 (US)
(74) Representative: Houghton, Mark Phillip

(57) **Abstract**

The present disclosure relates to displaying a bounded placement region for each radio frequency (RF) device in a map of a site to be used by an installer to install RF devices in the site.

## Description

### FIELD OF INVENTION

The present disclosure relates to radio frequency (RF) devices. More particularly, the disclosure relates to a placement tool for RF devices.

### BACKGROUND OF THE INVENTION

RF devices are wireless devices that can be installed on or in structures on a site to perform control or monitoring functions. Examples of RF devices include building controllers such as an active controller to permit or deny access through a door, a repeater, a fire alarm, a closed-circuit television monitor or a heating, ventilation and air conditioning controller. Industrial process controllers can also be RF devices.

RF devices can be installed by an RF installer according to a map of a site showing locations for the RF devices. The map can be generated by an RF device placement tool used by an RF planner who selects locations such that the RF devices may provide sufficient RF coverage and also communicate with each other.

RF device placement tools can have limitations. An RF installer may arrive at a site such as an industrial plant with a map showing locations for the RF devices only to find that one or more of these locations cannot properly support an RF device. Physical constraints may prevent the installation of an RF device. For example, a wall may be structurally unsound. An RF device may not be able to be fixed on some industrial structures such as a pipe or a tank. Structures such as cables may interfere with coverage of an RF device in a particular location. An RF installer may also have to move an RF device in a working system if there have been structural changes in the site. In these situations, the RF installer must find a new location for the RF device that will provide structural support, sufficient RF coverage and the ability to communicate with other RF devices.

There is therefore a need in the art for an RF device placement tool that can aid the RF installer to find new locations for RF devices when the originally planned locations are unsuitable. The embodiments of the present invention address this need.

### SUMMARY OF THE INVENTION

One embodiment the invention relates to placing radio frequency (RF) devices inside bounded placement regions in a map of a site, performing coverage calculations for the RF devices and generating the map to be used by an RF installer.

In another embodiment, the invention relates to determining the feasibility of installing a first RF device at a first location in a site where the first RF device is represented inside a first bounded placement region in a map of the site, installing the first RF device at the first location in the site when installation at the first location is feasible, and installing the first RF device at a second location inside the first bounded placement region in the site when installation at the first location is not feasible.

In still another embodiment, the invention relates to displaying a bounded placement region for each RF device in a map of a site to be used by an installer to install RF devices in the site, performing coverage calculations for RF devices in the bounded placement regions in the map and adding a bounded placement region for an RF device to the map or moving one of the bounded placement regions in the map in response to the coverage calculations.

### DETAILED DESCRIPTION OF THE DRAWINGS

FIG. 1 is a flowchart illustrating a method of a radio frequency (RF) device placement tool according to an embodiment of the invention.
FIG. 2 is a flowchart illustrating a method of installation according to a map from the RF device placement tool shown in FIG. 1 according to an embodiment of the invention.
FIG. 3 is a map from the RF device placement tool shown in FIG. 1 according to an embodiment of the invention.
FIG. 4 is a map from the RF device placement tool shown in FIG. 1 according to an embodiment of the invention.
FIG. 5 is a block diagram of a computer system that can be used to implement the RF device placement tool shown in FIG. 1 and the method of installation shown in FIG. 2 according to an embodiment of the invention.

### DETAILED DESCRIPTION OF THE INVENTION

In the following description, reference is made to the accompanying drawings that form a part hereof, and in which is shown by way of illustration specific embodiments which may be practiced. These embodiments are described in sufficient detail to enable those skilled in the art to practice the invention, and it is to be understood that other embodiments may be utilized and that structural, logical and electrical changes may be made without departing from the scope of the present invention. The following description of example embodiments is, therefore, not to be taken in a limited sense, and the scope of the present invention is defined by the appended claims.

The functions or algorithms described herein may be implemented in software or a combination of software and human implemented procedures in one embodiment. The software may consist of computer executable instructions stored on computer readable media such as memory or other type of storage devices. Further, such functions correspond to modules, which are software, hardware, firmware or any combination thereof. Multiple functions may be performed in one or more modules as desired, and the embodiments described are merely examples. The software may be executed on a digital signal processor, ASIC, microprocessor, or other type of processor operating on a computer system, such as a personal computer, server or other computer system.

Embodiments of the present invention relate to a radio frequency (RF) device placement tool that defines bounded placement regions within which an RF device may be installed to achieve sufficient RF coverage over a site such as a building or a plant. In various embodiments, the RF device placement tool is used to facilitate the installation of RF devices in the site.

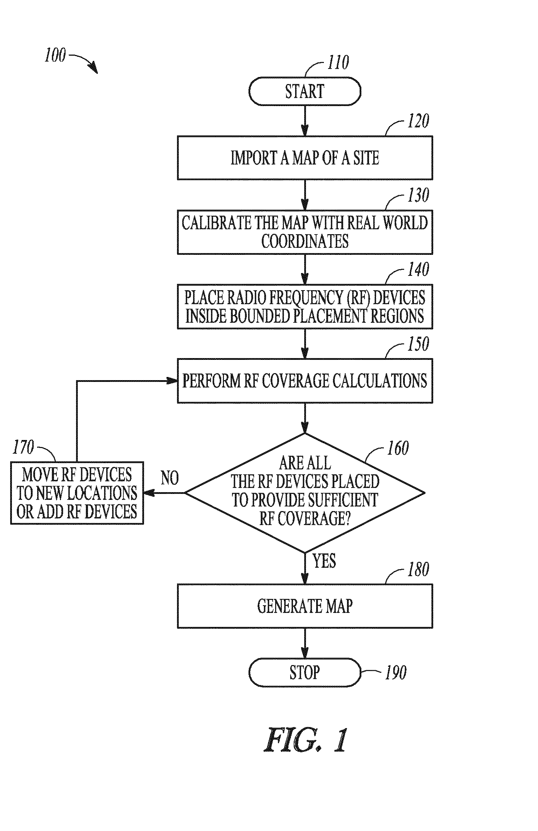

FIG. 1 is a flowchart illustrating a method of an RF device placement tool 100 according to an embodiment of the invention. The method starts at 110, and at 120 the method imports a map of a site in which RF devices are to be installed. The site may be a building or an industrial plant with several buildings or pieces of equipment. The RF devices may be installed inside one or more buildings and/or on the exterior of buildings and/or equipment. The map may comprise a jpeg file or a computer-aided design (CAD) file with pixel data. At 130, the method calibrates the map with real world coordinates to give the map dimensions and locations.

At 140, the method enables a user such as an RF planner to place RF devices on the map. Each RF device is placed inside a bounded placement region to indicate where the RF device may be installed to achieve sufficient RF coverage. Each bounded placement region may be represented in the map by a rectangle, a circle, an ellipse, a polygon or any other two-dimensional geometric figure. The bounded placement regions give an RF installer areas in which the RF devices may be installed to provide sufficient RF coverage.

At 150, the method performs RF coverage calculations for the RF devices placed on the map. The RF device placement tool 100 may generate different views of the map, such as a connectivity view, a coverage view and a heat map view. The connectivity view shows connectivity between the RF devices on the map. In other words, the connectivity view shows whether two RF devices can communicate with each other or not. The coverage view and the heat map view show the RF coverage of each of the RF devices in the map.

Each of the connectivity view, the coverage view and the heat map view show the locations of the RF devices and also the bounded placement region around each RF device. At 160, the method asks if all of the RF devices are placed to provide sufficient RF coverage. If one or more of the RF devices do not provide sufficient RF coverage, the method in 170 enables the user to move one or more RF devices with their bounded placement regions to new locations in the map. The method in 170 also enables the user to add RF devices inside bounded placement regions to the map. Following 170 the method returns to 150 to perform RF coverage calculations for the RF devices placed on the map. Should the method determine in 160 that the RF devices placed in the map provide sufficient RF coverage, the method generates an updated map that can be used by an RF installer in 180, and the method ends at 190.

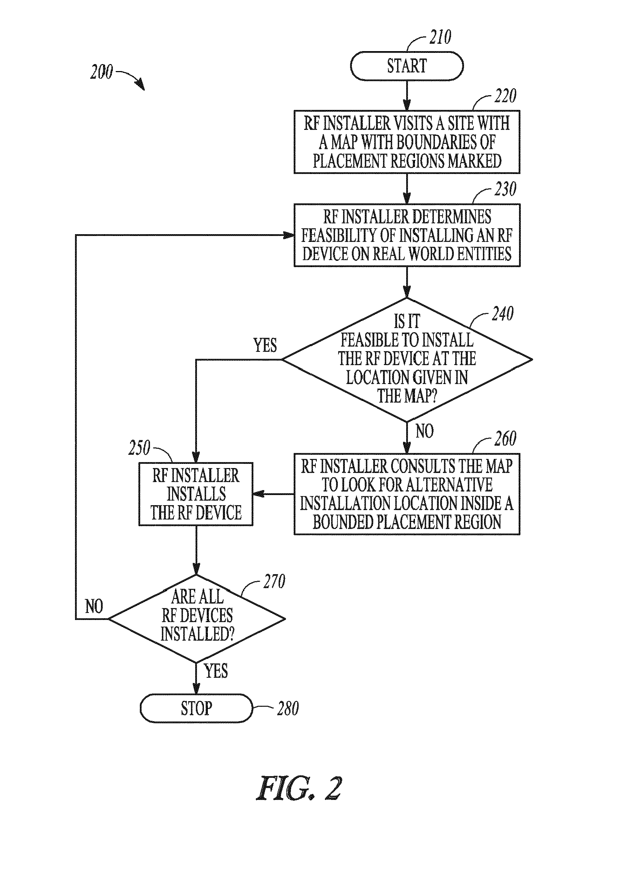

FIG. 2 is a flowchart illustrating a method of installation 200 according to a map from the RF device placement tool 100 shown in FIG. 1 according to an embodiment of the invention. The method is implemented by an RF installer to install RF devices on a site. The method starts at 210, and at 220 the RF installer visits a site with a map generated by the method 100 shown in FIG. 1. The RF installer has a hardcopy of the map or carries the map in a device such as a laptop or a tablet computer. The map includes marked boundaries of placement regions for RF devices. At 230, the RF installer determines the feasibility of installing an RF device on real world entities at the site according to the map. The real world entities are structures at the site such as, for example, buildings, walls, pipes, tanks and machines. At 240, the method asks if it is feasible to install the RF device at the location given in the map. If the RF installer determines that installation of the RF device is feasible on or in the real world entity, the RF installer installs the RF device in 250.

If the RF installer determines in 240 that installation of the RF device is not feasible for the location given in the map, the RF installer consults the map in 260 to look for an alternative installation location inside the bounded placement region associated with the RF device. The method then proceeds to 250 where the RF installer installs the RF device in the alternative location on the map that falls within the bounded placement region.

When the RF device has been installed in 250, the method asks in 270 if all of the RF devices in the map have been installed. If so, the method ends in 280. If another RF device needs to be installed, the method proceeds to 230 where the RF installer determines the feasibility of installing another RF device on real world entities at the site according to the map.

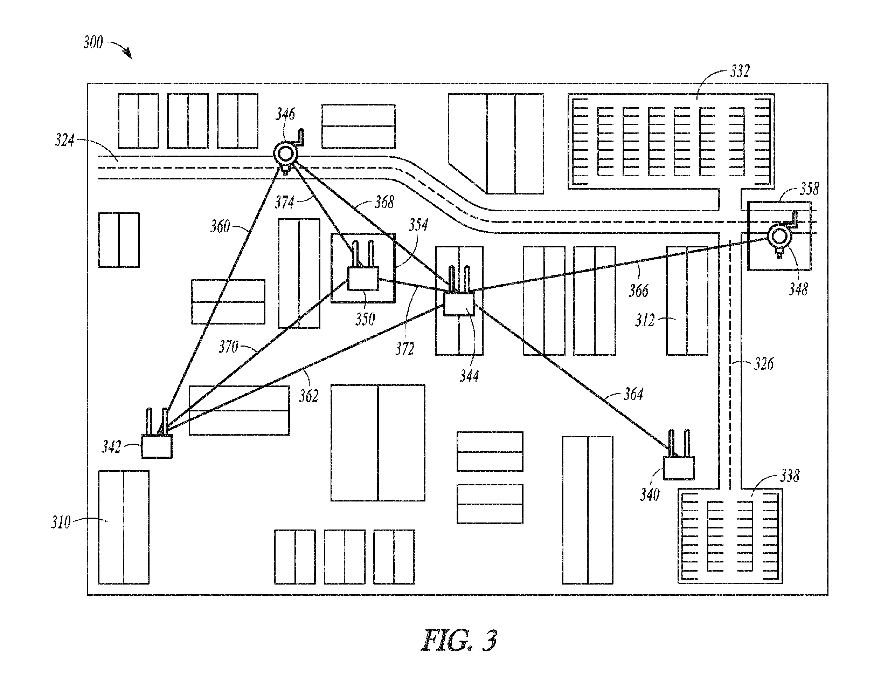

FIG. 3 is a map 300 from the RF device placement tool 100 shown in FIG. 1 according to an embodiment of the invention. The map 300 represents a connectivity view of an RF system, and may alternatively represent a coverage view or a heat map view of the RF system according to embodiments of the invention. The map 300 includes many structures such as buildings 310 and 312, streets 324 and 326 and parking lots 332 and 338. RF devices 340, 342, 344, 346, 348 and 350 are located on the map 300 and are either installed or planned to be installed. Additional buildings, streets and parking lots are shown in the map 300 but do not have reference numbers. The map 300 includes a first bounded placement region 354 and a second bounded placement region 358. The RF installer may install the RF device 350 anywhere in the first bounded placement region 354 to achieve sufficient coverage. Similarly, the RF installer may install the RF device 348 anywhere in the second bounded placement region 358 to achieve sufficient coverage. The map 300 also includes connectivity lines 360, 362, 364, 366, 368, 370, 372 and 374 that illustrate signal strength between the RF devices 340, 342, 344, 346, 348 and 350 with color. A white line can indicate good signal strength, and a red line can indicate poor signal strength.

The height or altitude of an intstalled RF device can be important in some contexts. For example, a Manual Call Point (MCP) or a card reader may need to be reached by a human user. Other RF devices that talk with the MCP or the card reader may need to be at a similar altitude. For example, the MCP can trigger a fire alarm when reached by a human user. The RF device placement tool 100 shown in FIG. 1 may generate a three-dimensional (3D) view of a map with 3D bounded placement regions. A 3D bounded placement region requires the RF installer to install the RF device at an altitude that is appropriate for it's purpose.

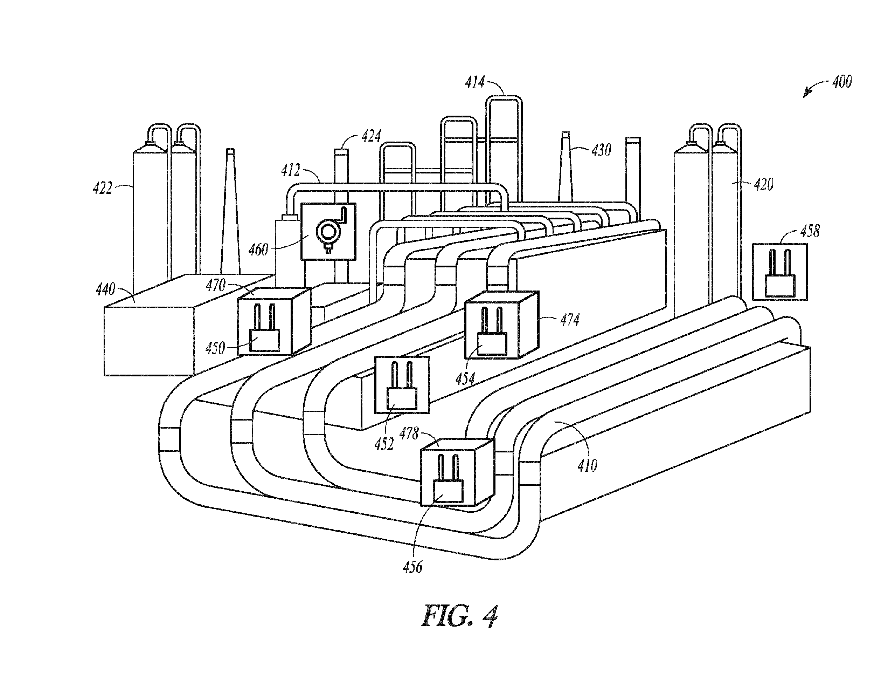

FIG. 4 is a map 400 from the RF device placement tool 100 shown in FIG. 1 according to an embodiment of the invention. The map 400 represents a 3D view of an RF system on the site of an industrial plant such as a refinery. The map 400 includes many structures such as pipes 410, 412 and 414, columns 420, 422 and 424, a stack 430 and a building 440. RF devices 450, 452, 454, 456, 458 and 460 are located on the map 400 and are either installed or planned to be installed. Additional pipes, columns and stacks are shown in the map 400 but do not have reference numbers. The map 400 includes a first 3D bounded placement region 470, a second 3D bounded placement region 474 and a third 3D bounded placement region 478. The RF installer may install the RF device 450 anywhere in the first 3D bounded placement region 470 to achieve sufficient coverage. Similarly, the RF installer may install the RF device 454 anywhere in the second 3D bounded placement region 474 and the RF device 456 anywhere in the third 3D bounded placement region 478 to achieve sufficient coverage. The 3D bounded placement regions 470, 474 and 478 may be Platonic solids or spheres or irregular 3D shapes. Each of the 3D bounded placement regions 470, 474 and 478 may have a unique shape.

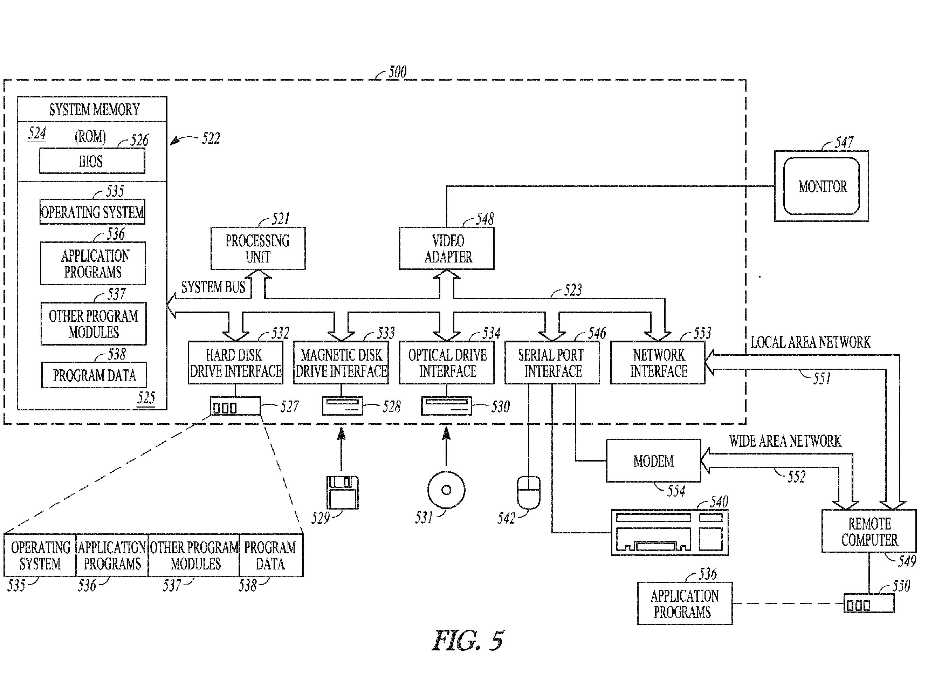

FIG. 5 is a block diagram of a computer system that can be used to implement the RF device placement tool 100 shown in FIG. 1 and the method of installation 200 shown in FIG. 2 according to embodiments of the invention. In the embodiment shown in FIG. 5, a hardware and operating environment is provided that is applicable to any of the nodes and monitors described in the various embodiments.

As shown in FIG. 5, one embodiment of the hardware and operating environment includes a general purpose computing device in the form of a computer 500 (e.g., a personal computer, workstation, or server), including one or more processing units 521, a system memory 522, and a system bus 523 that operatively couples various system components including the system memory 522 to the processing unit 521. There may be only one or there may be more than one processing unit 521, such that the processor of computer 500 comprises a single central-processing unit (CPU), or a plurality of processing units, commonly referred to as a multiprocessor or parallel-processor environment. In various embodiments, computer 500 is a conventional computer, a distributed computer, or any other type of computer.

The system bus 523 can be any of several types of bus structures including a memory bus or memory controller, a peripheral bus, and a local bus using any of a variety of bus architectures. The system memory can also be referred to as simply the memory, and, in some embodiments, includes read-only memory (ROM) 524 and random-access memory (RAM) 525. A basic input/output system (BIOS) program 526, containing the basic routines that help to transfer information between elements within the computer 500, such as during start-up, may be stored in ROM 524. The computer 500 further includes a hard disk drive 527 for reading from and writing to a hard disk, not shown, a magnetic disk drive 528 for reading from or writing to a removable magnetic disk 529, and an optical disk drive 530 for reading from or writing to a removable optical disk 531 such as a CD ROM or other optical media.

The hard disk drive 527, magnetic disk drive 528, and optical disk drive 530 couple with a hard disk drive interface 532, a magnetic disk drive interface 533, and an optical disk drive interface 534, respectively. The drives and their associated computer-readable media provide non volatile storage of computer-readable instructions, data structures, program modules and other data for the computer 500. It should be appreciated by those skilled in the art that any type of computer-readable media which can store data that is accessible by a computer, such as magnetic cassettes, flash memory cards, digital video disks, Bernoulli cartridges, random access memories (RAMs), read only memories (ROMs), redundant arrays of independent disks (e.g., RAID storage devices) and the like, can be used in the exemplary operating environment.

A plurality of program modules can be stored on the hard disk, magnetic disk 529, optical disk 531, ROM 524, or RAM 525, including an operating system 535, one or more application programs 536, other program modules 537, and program data 538. Programming for implementing one or more processes or method described herein may be resident on any one or number of these computer-readable media.

A user may enter commands and information into computer 500 through input devices such as a keyboard 540 and pointing device 542. Other input devices (not shown) can include a microphone, joystick, game pad, satellite dish, scanner, or the like. These other input devices are often connected to the processing unit 521 through a serial port interface 546 that is coupled to the system bus 523, but can be connected by other interfaces, such as a parallel port, game port, or a universal serial bus (USB). A monitor 547 or other type of display device can also be connected to the system bus 523 via an interface, such as a video adapter 548. The monitor 547 can display a graphical user interface for the user. In addition to the monitor 547, computers typically include other peripheral output devices (not shown), such as speakers and printers.

The computer 500 may operate in a networked environment using logical connections to one or more remote computers or servers, such as remote computer 549. These logical connections are achieved by a communication device coupled to or a part of the computer 500; the invention is not limited to a particular type of communications device. The remote computer 549 can be another computer, a server, a router, a network PC, a client, a peer device or other common network node, and typically includes many or all of the elements described above I/0 relative to the computer 500, although only a memory storage device 550 has been illustrated. The logical connections depicted in FIG. 5 include a local area network (LAN) 551 and/or a wide area network (WAN) 552. Such networking environments are commonplace in office networks, enterprise-wide computer networks, intranets and the internet, which are all types of networks.

When used in a LAN-networking environment, the computer 500 is connected to the LAN 551 through a network interface or adapter 553, which is one type of communications device. In some embodiments, when used in a WAN-networking environment, the computer 500 typically includes a modem 554 (another type of communications device) or any other type of communications device, e.g., a wireless transceiver, for establishing communications over the wide-area network 552, such as the internet. The modem 554, which may be internal or external, is connected to the system bus 523 via the serial port interface 546. In a networked environment, program modules depicted relative to the computer 500 can be stored in the remote memory storage device 550 of remote computer, or server 549. It is appreciated that the network connections shown are exemplary and other means of, and communications devices for, establishing a communications link between the computers may be used including hybrid fiber-coax connections, T1-T3 lines, DSL's, OC-3 and/or OC-12, TCP/IP, microwave, wireless application protocol, and any other electronic media through any suitable switches, routers, outlets and power lines, as the same are known and understood by one of ordinary skill in the art.

Embodiments of the invention described and claimed herein are not to be limited in scope by the specific embodiments herein disclosed, since these embodiments are intended as illustration of several aspects of the disclosure. Any equivalent embodiments are intended to be within the scope of this disclosure. Indeed, various modifications of the embodiments of the invention in addition to those shown and described herein will become apparent to those skilled in the art from the foregoing description. Such modifications are also intended to fall within the scope of the appended claims.

## Claims

1. A method comprising:
placing radio frequency (RF) devices inside bounded placement regions in a map of a site;
performing coverage calculations for the RF devices; and
generating an updated map to be used by an RF installer.

2. The method of claim 1, wherein placing RF devices inside bounded placement regions further comprises placing each RF device in a two-dimensional bounded placement region that is selected from the group consisting of a rectangle, a circle, an ellipse and a polygon.

3. The method of claim 1, wherein placing RF devices inside bounded placement regions further comprises placing each RF device in a three-dimensional bounded placement region that is selected from the group consisting of a Platonic solid and a sphere.

4. The method of claim 1-3, further comprising moving one or more of the RF devices and associated bounded placement regions in the map to improve coverage.

5. The method of claim 1-3, further comprising placing additional RF devices inside bounded placement regions in the map to improve coverage.

6. The method of claim 1-3, further comprising:
importing the map of the site; and
calibrating the map with real world coordinates.

7. A method comprising:
determining the feasibility of installing a first RF device at a first location in a site wherein the first RF device is represented inside a first bounded placement region in a map of the site;
installing the first RF device at the first location in the site when installation at the first location is feasible; and
installing the first RF device at a second location inside the first bounded placement region in the site when installation at the first location is not feasible.

8. The method of claim 7, further comprising:
determining the feasibility of installing a second RF device at a third location in the site wherein the second RF device is represented inside a second bounded placement region in the map of the site;
installing the second RF device at the third location in the site when installation at the third location is feasible; and
installing the second RF device at a fourth location inside the second bounded placement region in the site when installation at the third location is not feasible.

9. The method of claim 7-8, wherein installing the first RF device at the second location further comprises installing the first RF device at the second location inside a two-dimensional first bounded placement region in the site when installation at the first location is not feasible.

10. The method of claim 7-8, wherein installing the first RF device at the second location further comprises installing the first RF device at the second location inside a three-dimensional first bounded placement region in the site when installation at the first location is not feasible.
